# EUROPEAN PATENT SPECIFICATION

(11) **EP 3 502 046 B1**
(45) Date of publication and mention of the grant of the patent: **03.05.2023**
(21) Application number: 17841592.3
(22) Date of filing: 21.04.2017
(51) Int. Cl.: B81C 99/00, B21F 13/00, B21F 3/02, B21C 23/00, B21C 25/00

(54) **METHOD AND APPARATUS FOR MANUFACTURING MICRO-MOLDED PRODUCT BY USING METAL WIRE**
VERFAHREN UND VORRICHTUNG ZUR HERSTELLUNG EINES MIKROGEFORMTEN PRODUKTS UNTER VERWENDUNG VON METALLDRAHT
PROCÉDÉ ET APPAREIL PERMETTANT DE FABRIQUER UN PRODUIT MICRO-MOULÉ À L'AIDE D'UN FIL MÉTALLIQUE

(30) Priority: 19.08.2016 KR 20160105688
(43) Date of publication of application: 26.06.2019
(73) Proprietor: Korea Institute of Industrial Technology, Cheonan-si, Chungcheongnam-do 31056 (KR)
(72) Inventor: LEE, Min-Ha, Cheonan-si Chungcheongnam-do 31056 (KR); PARK, Gyu-Hyeon, Yongin-si Gyeonggi-do 17158 (KR); KIM, Song-Yi, Incheon 21560 (KR)
(74) Representative: Gulde & Partner
(86) International application number: PCT/KR2017/004257
(87) International publication number: WO 2018/034408

(56) References cited:
- KR-A- 20080 076 300
- KR-A- 20090 115 471
- KR-A- 20160 090 631
- KR-B1- 100 623 348
- US-A- 6 123 788
- US-A1- 2010 162 776
- US-A1- 2010 266 749
- US-A1- 2013 334 274

## Description

### Technical Field

The present invention relates generally to a method and an apparatus for manufacturing a micro-molded product by using a metal wire. More particularly, the present invention relates to a method and an apparatus for manufacturing a micro-molded product by using a metal wire, wherein a molding temperature is controlled to be included in a supercooled liquid temperature section or a specific high temperature deformation temperature section of the metal wire.

### Background Art

As well known in the art, microforming is a method for mass production of micro-parts, including microextrusion (gear, shaft, and the like), blow molding (various three-dimensional plate parts), embossing, and microstamping (nano-/micro-scaled surface patterns), and is a technique for forming nano-/micro-scaled surface patterns or for manufacturing metal micro-parts that can be applied to nano-/micro-systems.

Manufacturing of micro-parts using microforming can increase price competitiveness through mass production and also make it possible to manufacture three-dimensional micro-parts having a size of several tens of micrometers to several millimeters, which are difficult to be formed by a conventional manufacturing method and thus are manufactured only by MEMS or lithography.

Most metal alloys form a crystalline phase having an ordered atomic arrangement upon being solidified from a liquid phase. However, some alloys can maintain their disordered atomic structure of the liquid phase in a solid phase when the cooling rate applied to the solidification is high enough to exceed a critical value and to limit nucleation and growth of the crystalline phase. These alloys are generally called amorphous alloys or metallic glasses.

An amorphous metal has a much higher tensile strength than a crystalline metal due to the characteristics of an atomic structure and has other excellent properties such as toughness and corrosion resistance and is thus used in microforming.

The superplastic deformation of materials is a phenomenon in which deformation stability is increased at a specific deformation condition (temperature, strain rate, and the like), thus exhibiting a high elongation of several hundred percent or more. Superplastically deformed material exhibits a low flow stress of several MPa. When superplastic deformation is used in the industrial field, even complex parts can be easily manufactured with a low processing force, leading to a great increase in degree of freedom of parts design.

However, in microextrusion, when a metal alloy wire having superplastic deformation behavior and an amorphous metal are fed, the wire is deformed or broken. This results in a problem of feeding raw materials for microforming, and thus it is necessary to develop technology to solve this problem.

### Documents of Related Art

(Patent Document 1) Korean Patent No. 10-0893574

Patent document US 6,123,788 teaches a system for machining a thin copper wire to give it a specific cross-sectional shape. The wire is extruded by pulling it through a moulding die while winding the wire onto a reel.

### Disclosure

### Technical Problem

Accordingly, the present invention has been made keeping in mind the above problems occurring in the related art, and an objective of the present invention is to provide a method of manufacturing a micro-molded product by using a metal wire, wherein a molding temperature is controlled to be included in a supercooled liquid temperature section or a specific high temperature deformation temperature section of the metal wire, thus providing excellent mechanical properties, material homogeneity, and moldability.

Another objective of the present invention is to provide an apparatus for manufacturing a micro-molded product by using a metal wire, wherein a magnetorheological fluid (MR fluid) is used when a micro-wire is fed during microextrusion, whereby the wire is fed without undergoing deformation or breakage.

Still another objective of the present invention is to provide a micro-molded product, wherein three-dimensional micro-parts are manufactured in a size of several tens of micrometers to several millimeters and thus mass-production thereof is possible, thus finding application in microrobots, micro-system parts, biomedical system parts, electronic device parts, and the like.

However, the above objectives are described only for illustrative purposes and should not be construed as limiting the spirit and scope of the present invention.

### Technical Solution

In order to accomplish the above objectives, there is provided a method of manufacturing a micro-molded product by using a metal wire as defined in claim 4.

Further embodiments are defined in dependent claims.

According to another aspect of the present invention, there is provided an apparatus for manufacturing a micro-molded product by using a metal wire as defined in claim 1 or 2.

Further embodiments are defined in dependent claims.

.

### Advantageous Effects

According to a method and an apparatus for manufacturing a micro-molded product by using a metal wire according to the present invention, it is possible to control a molding temperature to be included in a supercooled liquid temperature section or a specific high temperature deformation temperature section of the metal wire, thus providing excellent mechanical properties, material homogeneity, and moldability.

Furthermore, a magnetorheological fluid (MR fluid) is used when a micro-wire is fed during microextrusion, whereby it is possible for the wire to be fed without undergoing deformation or breakage.

Furthermore, it is possible to manufacture three-dimensional micro-parts having a size of several tens of micrometers to several millimeters and thus mass production thereof is possible, thus finding application in microrobots, micro-system parts, biomedical system parts, electronic device parts, and the like.

The above effects of the present invention are described only for illustrative purposes and should not be construed as limiting the present invention.

### Description of Drawings

FIG. 1 is a view showing a shape of a magnetorheological fluid before and after a magnetic field is applied.
FIG. 2 is a view showing a behavior of the magnetorheological fluid.
FIG. 3 is a view showing metal wire feeding by using the magnetorheological fluid according to an embodiment of the present invention.
FIG. 4A is a view showing a method of manufacturing a micro-molded product by using a metal wire according to the embodiment of the present invention.
FIG. 4B is a view showing a mold shape of an extrusion die.
FIG. 5 is a view showing a typical DSC curve (schematic) for an amorphous alloy.
FIG. 6 is a view showing an amorphous alloy wire and a crystallization temperature thereof.
FIG. 7A is a cross-sectional view showing a metal wire feeding part according to the embodiment of the present invention.
FIG. 7B is a sectional view showing the metal wire feeding part according to the embodiment of the present invention.
FIG. 8A is a view showing a metal wire feeding method in which an inner tube of a gripper according to the embodiment of the present invention is made of a flexible material.
FIG. 8B is a view showing the metal wire feeding method in which the inner tube and an outer tube of the gripper according to the embodiment of the present invention are made of a flexible material.
FIG. 9 is a view showing a metal wire feeding part according to another embodiment of the present invention.

### Best Mode

Hereinbelow, exemplary embodiments of the present invention will be described in detail with reference to the accompanying drawings. The embodiments of the present invention are presented to make complete disclosure of the present invention and help those who are ordinarily skilled in the art best understand the invention. Various changes to the following embodiments are possible and the scope of the present invention is not limited to the following embodiments. The expression "and/or" is interpreted to include each of enumerated items, and all combinations including one or more items selected from among the enumerated items. The same reference numerals are used throughout the different drawings to designate the same or similar components. Further, various elements and regions in the drawings are schematically drawn. Accordingly, the spirit and the scope of the present invention are not limited by the relative size or spacing drawn in the accompanying drawings.

Microforming is a method for mass production of micro-parts, including microextrusion (gear, shaft, and the like), blow molding (various three-dimensional plate parts), embossing, and microstamping (nano-/micro-scaled surface patterns), and is a technique for forming nano-/micro-scaled surface patterns or for manufacturing metal micro-parts that can be applied to nano-/micro-systems.

A method of manufacturing a micro-molded product by using a metal wire according to the present invention includes: feeding the metal wire to a molding device by using a magnetorheological fluid (MR fluid); and manufacturing the metal wire into a molded product. The metal wire may have a diameter of 10 *µ*m to 500 *µ*m and may be a micro-wire. The magnetorheological fluid may include a magneto-caloric rheological fluid.

The feeding of the metal wire is a step of feeding the metal wire to the molding device by using the behavior of the magnetorheological fluid that behaves in response to application or interruption of a magnetic field. The feeding of the metal wire includes: holding the metal wire by applying the magnetic field to the magnetorheological fluid and then moving the metal wire; and feeding the metal wire to the molding device by removing the magnetic field from the magnetorheological fluid.

The magnetorheological fluid, which is a material of which rheological properties are rapidly changed by application of a magnetic field, changes to a solid having a high yield strength from a freely flowable liquid upon application of a magnetic field.

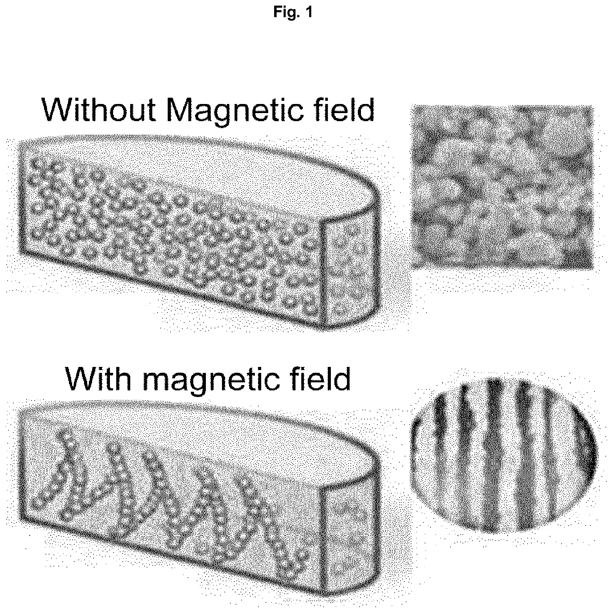

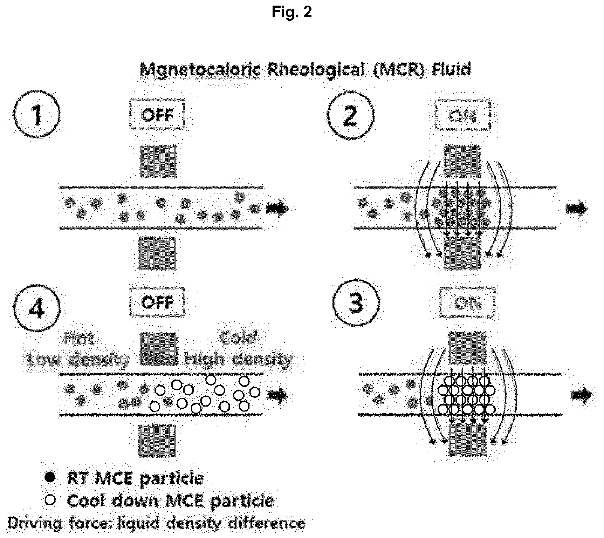

FIG. 1 is a view showing a shape of a magnetorheological fluid before and after a magnetic field is applied, and FIG. 2 is a view showing the behavior of the magnetorheological fluid. For example, as shown in FIGS. 1 and 2, the magnetorheological fluid is a suspension in which magnetic particles are dispersed in a nonmagnetic solution and exhibits magnetorheological phenomenon in which rheological behavior and electrical, thermal, mechanical, and physical properties are changed depending on the strength of a magnetic field externally applied.

The magnetorheological fluid can control a mechanical force, for example, has a high yield stress of 10 to 100 kPa or more upon application of an external magnetic field and can control the mechanical force through application of the magnetic field without the need of an additional apparatus, thus simplifying the design of application apparatuses. Furthermore, altering the strength of the applied magnetic field can control the properties of the fluid. Accordingly, the rheological properties can be changed by controlling the magnetic field, thus precisely controlling the flow characteristic.

As a result, when the micro-wire is fed by using the magnetorheological fluid to manufacture the micro-molded product, it is possible for the wire to be fed without undergoing deformation or breakage.

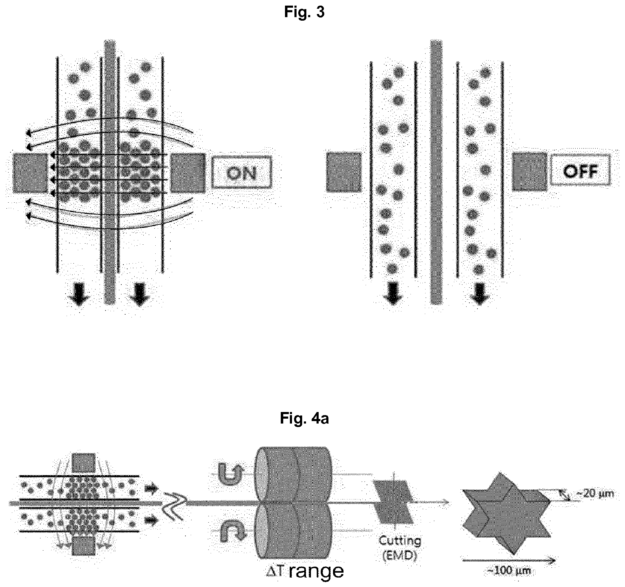

FIG. 3 is a view showing metal wire feeding by using the magnetorheological fluid according to an embodiment of the present invention. The feeding of the metal wire includes holding the metal wire by applying the magnetic field to the magnetorheological fluid and then moving the metal wire; and feeding the metal wire to the molding device by removing the magnetic field from the magnetorheological fluid. The metal wire is moved with being hold by the magnetorheological fluid which behaves like a solid upon application of the magnetic field, and then when the magnetic field is removed, the metal wire is separated from the magnetorheological fluid, which behaves like a liquid, and fed to the molding device.

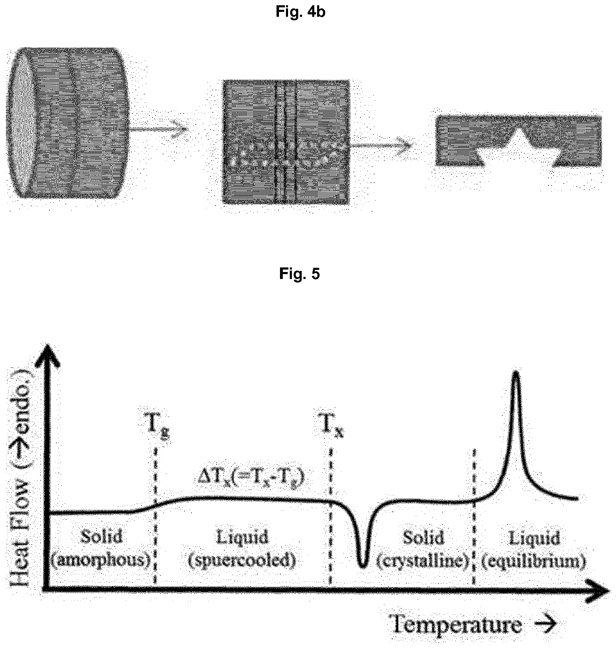

FIG. 4A is a view showing a method of manufacturing a micro-molded product by using a metal wire according to the embodiment of the present invention, and FIG. 4B is a view showing a mold shape of an extrusion die. The manufacturing of the metal wire into the molded product includes extruding and cutting. The extruding is a step of extruding the metal wire into a mold shape of an extrusion die, and the cutting is a step of cutting the extruded wire into a size of a final micro-molded product.

The metal wire may be a crystalline metal or alloy, or an amorphous metal or alloy. Furthermore, the temperature of the extrusion die is controlled to be included in a supercooled liquid temperature section of the amorphous metal or alloy or a high temperature deformation temperature section of the crystalline metal (for example, the superplasticity temperature or the softening temperature).

Furthermore, the method further includes, before the cutting the extruded wire, rotating the extrusion die or the extruded wire to manufacture a micro-molded product in a helical shape. In other words, during a process of cooling the molten amorphous metal or alloy, a molding device, the die, and the wire are rotated, thus manufacturing a helical-shaped gear.

Furthermore, the temperature of the extrusion die is controlled to a temperature between a glass transition temperature Tg and a crystallization temperature Tx of the amorphous alloy. The controlling of the temperature of the extrusion die to the temperature between the glass transition temperature Tg and the crystallization temperature Tx of the amorphous alloy makes it possible to manufacture a micro-molded product by using the amorphous alloy having excellent mechanical properties, material homogeneity, and moldability.

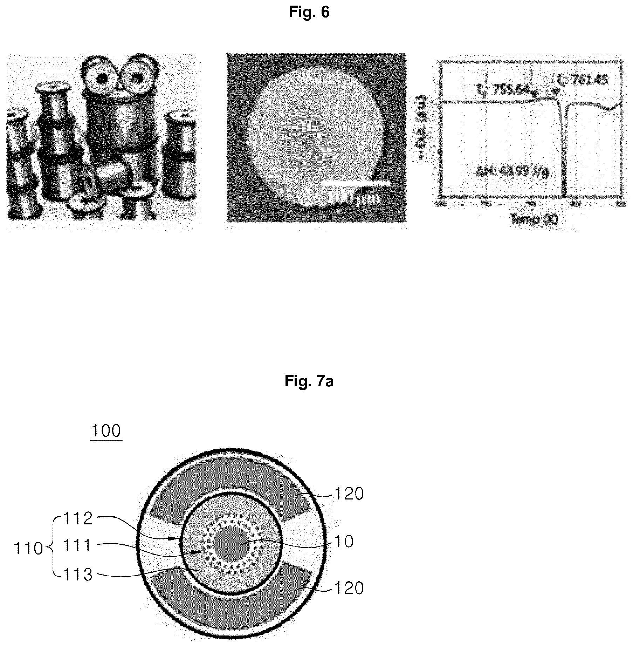

FIG. 5 is a view showing a typical DSC curve (schematic) for the amorphous alloy, and FIG. 6 is a view showing an amorphous alloy wire and the crystallization temperature thereof. The amorphous alloy, which is produced by a manufacturing process in which a liquid alloy is rapidly cooled and solidified without being crystallized under a supercooled state while being cooled below a melting point, has excellent mechanical properties, material homogeneity, and moldability. The amorphous alloy wire may be a commercially available amorphous wire and is formed in a specific temperature section ΔT (a section equal to or less than the crystallization temperature Tx).

As a result, it is possible to form the amorphous alloy wire into a micro-molded product by controlling the temperature of the extrusion die to the temperature between the glass transition temperature Tg and the crystallization temperature Tx of the amorphous alloy. The amorphous alloy in a supercooled liquid temperature section ΔTx exhibits Newtonian viscous flow with low viscosity and little deformation limitation, rather than plastic deformation. In this section, it is not only possible to perform forming with a small load, but also perform microforming due to excellent moldability.

Furthermore, the crystalline metal and alloy is softened at a high temperature to exhibit plastic deformation. In particular, a metal and an alloy, which show superplastic deformation at a specific temperature section, are controlled in temperature, thus exhibiting an elongation of several hundred percent or more.

An apparatus for manufacturing a micro-molded product by using a metal wire includes a forming part (not shown) and a metal wire feeding part.

The forming part serves to manufacture the metal wire 10 into a molded product. The forming part includes: an extrusion die for extruding the metal wire into the shape of the molded product; and a cutting device for cutting the extruded wire into a size of a final micro-molded product and may further include a rotary motor for rotating the extrusion die or the extruded wire to manufacture a micro-molded product having a helical shape.

When forming an amorphous metal or alloy, the temperature of the forming part at the temperature of the section ΔT (section equal to or less than the crystallization temperature Tx) is maintained. The amorphous wire having a diameter of 10 ,um to 500 ,um is fed to a hot forming press having a groove that has a shape corresponding to a cross-section shape of the final micro-molded product, and then the molded product such as an extruded gear having a specific cross-section shape is cut to a desirable length. The extrusion die may use different molds having different grooves depending on the purpose, and the final micro-molded product may be 10 *µ*m to 100 mm in length of each edge.

The metal wire feeding part 100 feeds the metal wire by using a magnetorheological fluid. The metal wire feeding part feeds the metal wire 10 to the forming part by using the behavior of the magnetorheological fluid that behaves in response to application or interruption of a magnetic field.

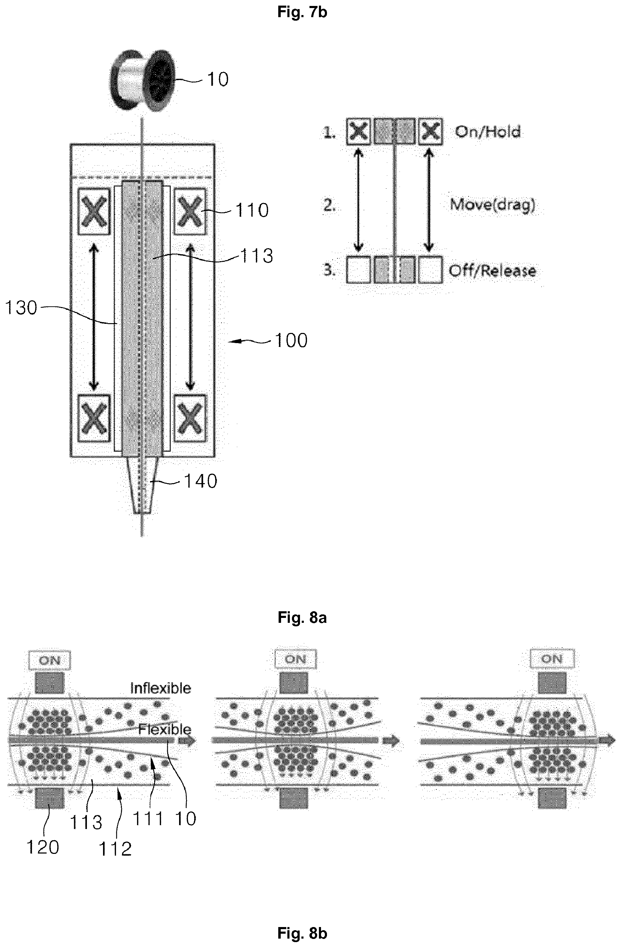

FIG. 7A is a cross-sectional view showing the metal wire feeding part according to the embodiment of the present invention, and FIG. 7B is a sectional view showing the metal wire feeding part according to the embodiment of the present invention. The metal wire feeding part 100 includes a gripper 110, an electromagnet 120, and a moving rail 130.

The gripper 110 has a flexible dual-cylindrical structure composed of an inner tube 111 and an outer tube 112. The gripper is filled with the magnetorheological fluid 113 between the inner tube 111 and the outer tube 112, such that the metal wire 10 fed into the inner tube 111 is held through partial solidification of the magnetorheological fluid 113.

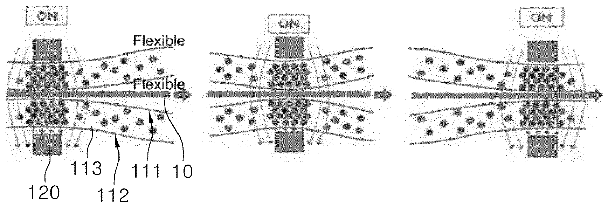

FIGS. 8A and 8B are views showing a metal wire feeding method. The gripper 110 is configured such that only the inner tube 111 is made of a flexible material as shown in FIG. 8A, or both the inner and outer tubes 111 and 112 are made of a flexible material as shown in FIG. 8B. The inner tube 111 has to be made of a stretchable material such that the metal wire 10 fed into the inner tube 111 is held through partial solidification of the magnetorheological fluid 113.

The electromagnets 120 are provided in a part of sectioned regions of the outer periphery of the outer tube 112 and allow the magnetorheological fluid 113 present in the gripper 110 to be attracted and solidified or to be dispersed through generation or removal of a magnetic field upon application or interruption of an electric current.

The moving rail 130 moves the electromagnets 120 along a longitudinal direction of the outer tube. Accordingly, the metal wire 10 is moved in a state of being held by the magnetorheological fluid 113 in conjunction with movement of the electromagnets.

FIG. 9 is a view showing a metal wire feeding part according to another embodiment of the present invention. The metal wire feeding part 100 includes a gripper 110 and electromagnets 120.

The gripper 110 has a flexible dual-cylindrical structure composed of an inner tube 111 and an outer tube 112. The gripper is filled with a magnetorheological fluid 113 between the inner tube 111 and the outer tube 112, such that a metal wire 10 fed into the inner tube 111 is held through partial solidification of the magnetorheological fluid 113.

The electromagnets 120 are provided on the outer periphery of the outer tube 112 in a longitudinal direction of the outer tube and allow the magnetorheological fluid 113 present in the gripper 110 to be attracted and solidified or to be dispersed through generation or removal of a magnetic field upon application or interruption of an electric current.

When the electric current is applied to a part of sectioned regions of the electromagnets 120, the metal wire 10 is held by the magnetorheological fluid 112 being solidified. When the part of the sectioned regions to which the electric current is applied is moved, the metal wire 10 is moved along the inner tube 111. In other words, when the part of the sectioned regions of the electromagnets 120 to which the electric current is applied is moved in a moving direction of the metal wire 10, that is, in a direction toward a nozzle 140, the metal wire 10 is moved thereby.

The method and apparatus for manufacturing the micro-molded product according to the present invention can manufacture a micro-molded product by using an amorphous or crystalline alloy having excellent mechanical properties, material homogeneity, and moldability. Furthermore, the magnetorheological fluid is used when a micro-metal wire is fed during microextrusion, whereby it is possible for the micro-metal wire to be fed without undergoing deformation or breakage.

Furthermore, it is possible to manufacture micro-parts having a size of several tens of micrometers to several millimeters in a three-dimensional shape and also to mass-produce micro-parts, thus significantly increasing the production amount of extrudable micro-parts such as micro-gears. Because the manufacturing of micro-gears using a conventional MEMS process has a large number of processes and takes a long time for each process, while having a high rate of occurrence of defective products, it takes a long time to obtain a finished product. However, the use of extrusion molding on the basis of a conventional metal forming technology concept makes it possible for a product to be freely formed in a short period of time within the durability of a mold.

Furthermore, in manufacturing of micro gears using the MEMS process, large devices such as a spin coater (JC-101), a mask aligner (MA6), a non-MESC Multiplex ICP, and a wet station are required in processes such as PR coating, exposure, dry, and etching. However, through the use of extrusion molding, it is possible to manufacture micro-parts such as micro-gears by using a minimum number of devices such as a piezoelectric actuator, a thermocouple, and a heater controller.

In other words, it is possible to solve problems such as high manufacturing cost, long process time, shortage of production facilities, limited use of materials, and the like, which are disadvantages of a conventional printing method. Furthermore, when the apparatus for manufacturing the micro-molded product according to the present invention is used, manufacturing cost other than mold manufacturing cost is low, which is advantageous over the conventional MEMS process.

Accordingly, the micro-molded product manufactured by using the metal wire according to the present invention can find wide application, such as in microrobots, micro-system parts, biomedical system parts, electronic device parts, and the like.

Although the exemplary embodiments of the present invention have been described for illustrative purposes, those skilled in the art will appreciate that various modifications, additions and substitutions are possible,.

**<Description of the Reference Numerals in the Drawings>**

| | | | |
|---|---|---|---|
| 10: | metal wire | 100: | metal wire feeding part |
| 110: | gripper | 111: | inner tube |
| 112: | outer tube | 113: | magnetorheological fluid |
| 120: | electromagnet | 130: | moving rail |
| 140: | nozzle | | |

## Claims

1. An apparatus for manufacturing a micro-molded product by using a metal wire, the apparatus comprising:
a metal wire feeding part (100) feeding the metal wire (10) by using a magnetorheological fluid, MR fluid, ; and
a forming part manufacturing the fed metal wire (10) into a molded-product, wherein the metal wire feeding part (100) includes:
a gripper (110) having a flexible dual-cylindrical structure and holding the metal wire through partial solidification of the magnetorheological fluid that is filled in the gripper;
an electromagnet (120) provided in a part of sectioned regions of an outer periphery of the gripper; and
a moving rail (130) moving the electromagnet along a longitudinal direction of the gripper,
wherein the metal wire (10) is moved in a held state in conjunction with movement of the electromagnet,
wherein the forming part includes:
an extrusion die extruding the metal wire into a shape of a molded product; and
a cutting device cutting the extruded wire into a size of a final micro-molded product.

2. An apparatus for manufacturing a micro-molded product by using a metal wire, the apparatus comprising:
a metal wire feeding part (100) feeding the metal wire by using a magnetorheological fluid, MR fluid; and
a forming part manufacturing the fed metal wire into a molded-product,
wherein the metal wire feeding part includes:
a gripper (110) having a flexible dual-cylindrical structure and holding the metal wire through partial solidification of the magnetorheological fluid that is filled in the gripper; and
an electromagnet (120) provided on an outer periphery of the gripper in a longitudinal direction of the gripper,
wherein when an electric current is applied to a part of sectioned regions of the electromagnet, the metal wire is held, and when the part of the sectioned regions to which the electric current is applied is moved, the metal wire is moved thereby,
wherein the forming part includes:
an extrusion die extruding the metal wire into a shape of a molded product; and
a cutting device cutting the extruded wire into a size of a final micro-molded product.

3. The apparatus of claim 1 or 2, further comprising:
a rotary motor rotating the extrusion die or the extruded wire to manufacture a micro-molded product having a helical shape.

4. A method of manufacturing a micro-molded product by using a metal wire, the method comprising:
feeding the metal wire (10) to a molding device by using a magnetorheological fluid, MR fluid, and by using the apparatus of claim 1 or 2; and
manufacturing the metal wire (10) into a molded product,
wherein the manufacturing of the metal wire into the molded product includes:
extruding the metal wire (10) by using an extrusion die having a shape corresponding to a shape of the molded product; and
cutting the extruded metal wire into a size of a final micro-molded product.

5. The method of claim 4, wherein the feeding of the metal wire includes:
holding the metal wire (10) by applying a magnetic field to the magnetorheological fluid and then moving the metal wire; and
feeding the metal wire to the molding device by removing the magnetic field.

6. The method of claim 4, the manufacturing of the metal wire into the molded product further comprising:
before the cutting the extruded metal wire (10),
rotating the extrusion die or the extruded wire to manufacture the micro-molded product in a helical shape.

7. The method of claim 4, wherein the metal wire (10) has a diameter of 10 *µ*m to 500 *µ*m.

8. The method of claim 4, wherein the metal wire (10) is a crystalline metal or alloy, or an amorphous metal or alloy.

9. The method of claim 8, wherein a temperature of the extrusion die is controlled to be included in a supercooled liquid temperature section of the amorphous metal or alloy or a high temperature deformation temperature section of the crystalline metal.

## Patentansprüche

1. Vorrichtung zur Herstellung eines mikrogeformten Produkts unter Verwendung eines Metalldrahtes, wobei die Vorrichtung umfasst:
ein Metalldraht-Zuführungsteil (100), das den Metalldraht (10) unter Verwendung eines magnetorheologischen Fluids, MR-Fluid, zuführt; und
ein Formteil, das den zugeführten Metalldraht (10) zu einem geformten Produkt verarbeitet, wobei das Metalldraht-Zuführungsteil (100) umfasst:
einen Greifer (110), der eine flexible doppelzylindrische Struktur aufweist und den Metalldraht durch partielle Verfestigung des magnetorheologischen Fluids, das in den Greifer gefüllt ist, hält;
einen Elektromagneten (120), der in einem Teil von in Abschnitte unterteilten Bereichen eines Außenumfangs des Greifers vorgesehen ist; und
eine bewegliche Schiene (130), die den Elektromagneten entlang einer Längsrichtung des Greifers bewegt,
wobei der Metalldraht (10) in einem gehaltenen Zustand in Verbindung mit der Bewegung des Elektromagneten bewegt wird,
wobei das Formteil umfasst:
eine Extrusionsdüse, die den Metalldraht in die Form eines geformten Produkts extrudiert; und
eine Schneidevorrichtung, die den extrudierten Draht auf eine Größe eines mikrogeformten Endprodukts schneidet.

2. Vorrichtung zur Herstellung eines mikrogeformten Produkts unter Verwendung eines Metalldrahtes, wobei die Vorrichtung umfasst:
ein Metalldraht-Zuführungsteil (100), das den Metalldraht unter Verwendung eines magnetorheologischen Fluids, MR-Fluid, zuführt; und
ein Formteil, das den zugeführten Metalldraht zu einem geformten Produkt verarbeitet,
wobei das Metalldraht-Zuführungsteil umfasst:
einen Greifer (110), der eine flexible doppelzylindrische Struktur aufweist und den Metalldraht durch partielle Verfestigung des magnetorheologischen Fluids, das in den Greifer gefüllt ist, hält; und
einen Elektromagneten (120), der an einem Außenumfang des Greifers in einer Längsrichtung des Greifers vorgesehen ist,
wobei, wenn ein elektrischer Strom an einen Teil von in Abschnitte unterteilten Bereichen des Elektromagneten angelegt wird, der Metalldraht gehalten wird, und wenn der Teil der in Abschnitte unterteilten Bereiche, an den der elektrische Strom angelegt wird, bewegt wird, der Metalldraht dadurch bewegt wird,
wobei das Formteil umfasst:
eine Extrusionsdüse, die den Metalldraht in die Form eines geformten Produkts extrudiert; und
eine Schneidevorrichtung, die den extrudierten Draht auf die Größe eines mikrogeformten Endprodukts schneidet.

3. Vorrichtung nach Anspruch 1 oder 2, ferner umfassend: einen Drehmotor, der die Extrusionsdüse oder den extrudierten Draht dreht, um ein mikrogeformtes Produkt mit einer spiralförmigen Form herzustellen.

4. Verfahren zur Herstellung eines mikrogeformten Produkts unter Verwendung eines Metalldrahts, wobei das Verfahren umfasst:
Zuführen des Metalldrahtes (10) zu einer Formvorrichtung unter Verwendung eines magnetorheologischen Fluids, MR-Fluid, und unter Verwendung der Vorrichtung nach Anspruch 1 oder 2; und
Verarbeiten des Metalldrahtes (10) zu einem geformten Produkt,
wobei das Verarbeiten des Metalldrahtes zu dem geformten Produkt umfasst:
Extrudieren des Metalldrahtes (10) unter Verwendung einer Extrusionsdüse mit einer Form, die einer Form des geformten Produkts entspricht; und
Schneiden des extrudieren Metalldrahtes auf eine Größe eines mikrogeformten Endprodukts.

5. Verfahren nach Anspruch 4, wobei das Zuführen des Metalldrahtes umfasst:
Halten des Metalldrahtes (10) durch Anlegen eines Magnetfeldes an das magnetorheologische Fluid und anschließendes Bewegen des Metalldrahtes; und
Zuführen des Metalldrahtes zur Formvorrichtung durch Entfernen des Magnetfeldes.

6. Verfahren nach Anspruch 4, wobei das Verarbeiten des Metalldrahtes zu dem geformten Produkt weiterhin umfasst:
vor dem Schneiden des extrudierten Metalldrahtes (10),
Drehen der Extrusionsdüse oder des extrudierten Drahtes, um das mikrogeformte Produkt in einer spiralförmigen Form herzustellen.

7. Verfahren nach Anspruch 4, wobei der Metalldraht (10) einen Durchmesser von 10 *µ*m bis 500 *µ*m aufweist

8. Verfahren nach Anspruch 4, wobei der Metalldraht (10) ein kristallines Metall oder eine kristalline Legierung oder ein amorphes Metall oder eine amorphe Legierung ist.

9. Verfahren nach Anspruch 8, wobei die Temperatur der Extrusionsdüse so gesteuert wird, dass sie in einem Temperaturbereich für unterkühlte Flüssigkeiten des amorphen Metalls oder der amorphen Legierung oder in einem Temperaturbereich für Hochtemperaturverformung des kristallinen Metalls liegt.

## Revendications

1. Appareil pour la fabrication d'un produit micro-moulé en utilisant un fil métallique, l'appareil comprenant :
une partie d'alimentation en fil métallique (100) alimentant le fil métallique (10) à l'aide d'un fluide magnétorhéologique, fluide MR ; et
une partie de formage transformant le fil métallique alimenté (10) en un produit moulé, dans laquelle la partie d'alimentation en fil métallique (100) comprend :
une griffe (110) ayant une structure flexible à deux cylindres et retenant le fil métallique par solidification partielle du fluide magnétorhéologique rempli dans la griffe ;
un électro-aimant (120) prévue dans une partie de régions sectionnées d'une périphérie extérieure de la griffe ; et
un rail mobile (130) déplaçant l'électro-aimant le long d'une direction longitudinale de la griffe,
dans lequel le fil métallique (10) est déplacé dans un état de retenue en conjonction avec le mouvement de l'électro-aimant,
dans lequel la partie de formage comprend :
une filière d'extrusion extrudant le fil métallique dans une forme de produit moulé ; et
un dispositif de coupe qui coupe le fil extrudé à la taille d'un produit final micro-moulé.

2. Appareil pour la fabrication d'un produit micro-moulé en utilisant un fil métallique, l'appareil comprenant :
une partie d'alimentation en fil métallique (100) alimentant le fil métallique à l'aide d'un fluide magnétorhéologique, fluide MR ; et
une partie de formage transformant le fil métallique alimenté en un produit moulé,
dans lequel le dispositif d'alimentation en fil métallique comprend
une griffe (110) ayant une structure flexible à deux cylindres et retenant le fil métallique par solidification partielle du fluide magnétorhéologique rempli dans la griffe ; et
un électro-aimant (120) prévue sur une périphérie extérieure de la griffe dans une direction longitudinale de la griffe,
dans lequel, lorsqu'un courant électrique est appliqué à une partie de régions sectionnées de l'électro-aimant, le fil métallique est retenu, et lorsque la partie des régions sectionnées à laquelle le courant électrique est appliqué est déplacée, le fil métallique est déplacé en conséquence,
dans lequel la partie de formage comprend :
une filière d'extrusion extrudant le fil métallique dans une forme de produit moulé ; et
un dispositif de coupe qui coupe le fil extrudé à la taille d'un produit final micro-moulé.

3. Appareil selon la revendication 1 ou 2, comprenant en outre :
un moteur rotatif faisant tourner la filière d'extrusion ou le fil extrudé pour fabriquer un produit micro-moulé ayant une forme hélicoïdale.

4. Procédé de fabrication d'un produit micro-moulé en utilisant un fil métallique, comprenant :
alimenter le fil métallique (10) dans un dispositif de moulage à l'aide d'un fluide magnétorhéologique, fluide MR, et en utilisant l'appareil selon la revendication 1 ou 2 ; et
transformer le fil métallique (10) en un produit moulé,
dans lequel la fabrication du fil métallique dans le produit moulé comprend :
extruder le fil métallique (10) à l'aide d'une filière d'extrusion dont la forme correspond à celle du produit moulé ; et
couper le fil métallique extrudé à la taille d'un produit final micro-moulé.

5. Procédé selon la revendication 4, dans laquelle l'alimentation du fil métallique comprend :
retenir le fil métallique (10) en appliquant un champ magnétique au fluide magnétorhéologique, puis déplacer le fil métallique ; et
alimenter fil métallique vers le dispositif de moulage en supprimant le champ magnétique.

6. Procédé selon la revendication 4, la fabrication du fil métallique dans le produit moulé comprenant en outre :
avant de couper le fil métallique extrudé (10),
faire tourner la filière d'extrusion ou le fil extrudé pour fabriquer le produit micro-moulé en forme d'hélice.

7. Procédé selon la revendication 4, dans laquelle le fil métallique (10) a un diamètre de 10 *µ*m à 500 *µ*m.

8. Procédé selon la revendication 4, dans laquelle le fil métallique (10) est un métal ou un alliage cristallin, ou un métal ou un alliage amorphe.

9. Procédé selon la revendication 8, dans laquelle la température de la filière d'extrusion est contrôlée pour être incluse dans une section de température de liquide surfondu du métal ou de l'alliage amorphe ou dans une section de température de déformation à haute température du métal cristallin.
